# FASCICULE DE BREVET EUROPEEN

(11) **EP 2 761 717 B1**
(45) Date de publication et mention de la délivrance du brevet: **31.10.2018**
(21) Numéro de dépôt: 12773088.5
(22) Date de dépôt: 26.09.2012
(51) Int. Cl.: H02J 7/00, B60L 11/18, B60R 16/00, H04B 3/54, H02J 7/08, H03M 1/00, B60R 16/03, H02J 7/04

(54) **DISPOSITIF DE COMMUNICATION PAR COURANTS PORTEURS EN LIGNE ET MULTIPLEXAGE FRÉQUENTIEL DANS UNE LIGNE PILOTE, ET SYSTÈMES ASSOCIÉS**
KOMMUNIKATIONSVORRICHTUNG UNTER VERWENDUNG VON STROMLEITUNGSKOMMUNIKATION UND FREQUENZMULTIPLEXVERFAHREN AUF EINER STEUERLEITUNG UND ZUGEHÖRIGE SYSTEME
COMMUNICATION DEVICE USING POWER LINE COMMUNICATION AND FREQUENCY-DIVISION MULTIPLEXING ON A PILOT LINE, AND RELATED SYSTEMS

(30) Priorité: 27.09.2011 FR 1158610
(43) Date de publication de la demande: 06.08.2014
(73) Titulaire: PSA Automobiles SA, 78300 Poissy (FR)
(72) Inventeur: MORAND, Nicolas, F-92400 Courbevoie (FR)
(74) Mandataire: Jeannin, Laurent Jean-Pierre
(86) Numéro de dépôt international: PCT/FR2012/052155
(87) Numéro de publication internationale: WO 2013/045823

(56) Documents cités:
- EP-A1- 1 865 623
- EP-A2- 2 228 882
- WO-A1-2011/045925
- KR-B1- 100 963 793
- US-A- 4 639 609
- US-A1- 2010 164 439
- EV CHARGING SYSTEMS COMMITEE: "(R) SAE Electric Vehicle Conductive Charge Coupler J1772", 19961001 , vol. J1772, no. REV. NOV2001 1 octobre 1996 (1996-10-01), pages 1-32, XP002666503, Extrait de l'Internet: URL:http://bzwxw.com/soft/UploadSoft/new5/ SAE--J1772-2001.pdf [extrait le 2012-01-02]

## Description

L'invention concerne l'alimentation en tension de certains systèmes par d'autres systèmes, via un câble électrique.

Comme le sait l'homme de l'art, certains systèmes, comme par exemple certains véhicules, éventuellement de type automobile, doivent être alimentés en tension par d'autres systèmes, comme par exemple un point de recharge (borne de recharge ou prise de courant), afin de pouvoir continuer à fonctionner, au moins partiellement.

Par exemple, dans le cas non limitatif d'un véhicule de type hybride ou tout électrique, l'interconnexion de ce dernier à un point de recharge est destinée à permettre le rechargement de sa (ses) batterie(s) électrique(s) rechargeable(s).

L'invention vise plus particulièrement, bien que non exclusivement, l'alimentation en tension alternative.

Dans certains pays ou régions, des normes régissent l'alimentation en tension de certains systèmes. C'est notamment le cas de la norme ISO/CEI 61851-1 qui concerne le rechargement des batteries électriques des véhicules. Cette norme définit quatre « modes de charge », un pour la tension continue et trois pour la tension alternative (mode 1 : charge directe sur une prise de courant simple, par exemple domestique ; mode 2 : charge sur une prise de courant simple, par exemple domestique, via un boîtier faisant partie du câble électrique d'interconnexion ; mode 3 : charge sur une borne de recharge publique ou privée, plus complexe qu'une prise de courant simple).

Dans le mode 3, la borne de recharge fournit une tension sous un courant élevé si et seulement si une communication adéquate est établie sur une ligne dite « pilote » faisant partie du câble électrique d'interconnexion et comportant un fil pilote et un fil de terre constituant ensemble une partie d'un réseau de communication simple entre la borne de recharge et le véhicule. La communication peut également permettre à la borne de recharge d'indiquer au véhicule la valeur maximale du courant qu'elle peut lui fournir.

Plus précisément, dans ce mode 3 la borne de recharge génère à destination du véhicule un signal rectangulaire (par exemple présentant une fréquence égale à 1 kHz), dont la largeur d'impulsion est représentative de la valeur maximale du courant qu'elle peut fournir au véhicule. Ce signal est donc de type dit « à modulation de largeur d'impulsion » ou PWM (pour « Pulse Width Modulation »). Du côté du véhicule, la liaison électrique avec la ligne pilote est couplée, d'une part, à un module d'analyse, et, d'autre part, à au moins une diode et une première résistance montées en série (on peut également prévoir une seconde résistance et un commutateur montés en parallèle de la première résistance).

La première résistance étant couplée au fil de terre et à la masse (généralement le châssis), elle permet, lorsque l'interconnexion véhicule-borne de recharge est conforme (en particulier en ce qui concerne la terre), de signaler cette conformité à la borne de recharge. Le module d'analyse est chargé de mesurer la largeur d'impulsion des signaux rectangulaires du premier signal (en permanence pendant la charge) afin de déterminer la valeur maximale du courant offert par la borne de recharge pour ne jamais consommer un courant de recharge supérieur à cette valeur maximale disponible. On notera que cette dernière est généralement comprise entre 6 A et 80 A par phase.

La seconde résistance et le commutateur sont destinés à signaler à la borne de recharge si elle est autorisée ou non à alimenter le véhicule en tension, selon que le commutateur est fermé ou ouvert. On notera qu'en l'absence de seconde résistance et de commutateur dès que l'interconnexion véhicule-borne de recharge est établie de façon conforme, la borne de recharge peut fournir du courant.

On notera également qu'une communication véhicule-borne de recharge similaire à celle décrite ci-avant est mise en oeuvre dans le mode 2 précité via le boîtier du câble électrique d'interconnexion.

Lorsque le véhicule et la borne de recharge (par exemple) doivent échanger d'autres informations que celle relative à la valeur maximale du courant disponible, comme par exemple des informations relatives à la facturation de la recharge ou à la gestion de la puissance électrique disponible, une autre communication doit être établie entre eux. Cette autre communication peut se faire par l'intermédiaire de deux modems équipant respectivement le véhicule et la borne de recharge, généralement via la technique dite des « courants porteurs en ligne » (ou PLC (« Power Line Communication »)). Plus précisément, selon les technologies connues de l'homme de l'art, ces modems sont connectés à l'une des liaisons du véhicule et de la borne de recharge qui sont dédiées aux lignes de puissance, généralement via des circuits analogiques de couplage (comportant des condensateurs et/ou des tores électromagnétiques), afin de ne pas interférer avec la fourniture de la puissance et de ne pas perturber le premier signal qui circule sur la ligne pilote. Hélas, ce type de communication sur une ligne de puissance induit une diaphonie élevée dans de nombreuses conditions et donc les informations échangées peuvent être captées relativement facilement par des équipements de communication situés dans le voisinage du véhicule et de la borne de recharge, et notamment les modems de véhicules voisins, ce qui nuit notamment à la confidentialité et à la sécurité des transactions.

On connait par le document US2010/164439 un dispositif destiné à améliorer le rechargement d'une batterie d'un véhicule.

On connait aussi par le document WO201145925 un système de secours pour coupures de courant comprenant : un dispositif de source d'alimentation électrique à l'intérieur d'une résidence; et un véhicule qui peut être connecté au dispositif de source d'alimentation électrique ou en être isolé au moyen d'un câble d'alimentation électrique. Le dispositif de source d'alimentation électrique utilise le câble d'alimentation électrique pour transmettre de l'information de commande servant à commander le véhicule en cas de coupure de courant.

L'invention a donc pour but d'améliorer la situation, et en particulier l'échange d'informations entre deux systèmes lorsque l'un d'entre eux alimente l'autre en courant électrique via un câble électrique (d'interconnexion).

Elle propose notamment à cet effet un dispositif de communication par courants porteurs en ligne, destiné à équiper un système qui est propre à être couplé à un autre système via un câble électrique qui comporte une ligne pilote ayant une première impédance dite caractéristique, voyant au moins des deuxième et troisième impédances (respectivement dans ces deux systèmes) et dans laquelle circule un premier signal analogique situé dans une première bande de fréquences.

Ce dispositif de communication se caractérise par le fait qu'il est agencé :
- pour générer à partir d'un signal numérique local (issu de son système) un second signal analogique de courants porteurs en ligne qui a des fréquences comprises dans une deuxième bande de fréquences qui recouvre le moins possible la première bande de fréquences,
- pour alimenter la ligne pilote avec le second signal analogique via des moyens capacitifs, et
- pour extraire des signaux analogiques qui circulent dans la ligne pilote chaque second signal analogique afin de le convertir en un signal numérique devant être traité par son système.

Grâce à l'invention, on peut désormais injecter sur la ligne pilote des signaux de courants porteurs en ligne multiplexés en fréquence avec d'autres signaux analogiques, ce qui permet de réduire (très) fortement la diaphonie.

Le dispositif de communication selon l'invention peut comporter d'autres caractéristiques qui peuvent être prises séparément ou en combinaison, et notamment :
- les moyens capacitifs peuvent présenter une quatrième impédance qui est strictement inférieure aux première, deuxième et troisième impédances ;
- il peut comprendre, d'une première part, des moyens de conversion propres à convertir un signal analogique en un signal numérique et réciproquement, d'une deuxième part, des premiers moyens de génération propres à générer chaque second signal analogique à partir d'un signal analogique local fourni par les moyens de conversion, et à alimenter ses moyens capacitifs avec chaque second signal analogique généré, d'une troisième part, des premiers moyens de filtrage propres à extraire chaque second signal analogique des signaux analogiques qui circulent dans la ligne pilote, et, d'une quatrième part, des seconds moyens de génération propres à générer à partir de chaque second signal analogique extrait un signal analogique devant être converti en signal numérique par les moyens de conversion, en vue de son traitement par le système ;
   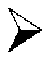 les premiers moyens de génération peuvent comprendre, d'une part, des premiers moyens d'interface agencés pour générer un premier signal différentiel analogique de courants porteurs en ligne à partir d'un signal analogique fourni par les moyens de conversion, et, d'autre part, un premier générateur de tension agencé pour générer un second signal analogique de courants porteurs en ligne à partir d'un premier signal différentiel analogique généré par les premiers moyens d'interface, et pour alimenter les moyens capacitifs avec ce second signal analogique généré ;
   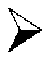 les seconds moyens de génération peuvent comprendre, d'une part, un second générateur de tension agencé pour générer un second signal différentiel analogique de courants porteurs en ligne à partir d'un second signal analogique extrait par les premiers moyens de filtrage, et, d'autre part, des seconds moyens d'interface agencés pour générer un signal analogique de courants porteurs en ligne devant être converti en signal numérique par les moyens de conversion, à partir d'un second signal différentiel analogique fourni par le second générateur de tension ;
   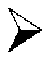 les premiers moyens de filtrage peuvent être agencés pour extraire des signaux analogiques circulant dans la ligne pilote des seconds signaux analogiques dont la deuxième bande de fréquences est supérieure à la première bande de fréquences.

L'invention propose également un système, d'une part, propre à être couplé à un autre système via un câble électrique qui comporte une ligne pilote ayant une première impédance, voyant au moins des deuxième et troisième impédances (respectivement dans ces deux systèmes) et dans laquelle circule un premier signal analogique situé dans une première bande de fréquences, et, d'autre part, comprenant un dispositif de communication par courants porteurs en ligne du type de celui présenté ci-avant et destiné à être couplé à cette ligne pilote.

Ce système selon l'invention peut comporter d'autres caractéristiques qui peuvent être prises séparément ou en combinaison, et notamment :
- dans un premier mode de réalisation il peut constituer une partie au moins d'une borne de recharge, et comprendre des moyens de génération agencés pour générer le premier signal analogique ;
   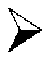 les moyens de génération peuvent être agencés pour générer un premier signal analogique de type dit « à modulation de largeur d'impulsion » (ou PWM), et dans lequel la largeur d'impulsion est représentative de la valeur maximale d'un courant que la borne de recharge est capable de fournir ;
      - les moyens de génération peuvent être agencés pour générer un premier signal analogique qui présente une forme générale rectangulaire à transitions arrondies ;
         ∘ les moyens de génération peuvent comprendre, d'une première part, un générateur agencé pour générer un signal de forme rectangulaire ayant une première fréquence fondamentale située en bas de la première bande de fréquences, d'une deuxième part, des moyens de commutation agencés pour modifier le passage du signal généré par le générateur pendant une petite partie choisie de chacune de ses transitions de manière à arrondir ces dernières, et, d'une troisième part, des seconds moyens de filtrage agencés pour appliquer un filtrage de type passe-bas au signal délivré par les moyens de commutation de manière à augmenter la durée de leurs transitions arrondies ;
- dans un second mode de réalisation il peut constituer une partie au moins d'un véhicule, éventuellement de type automobile, et comprendre des moyens de gestion agencés pour extraire des signaux analogiques qui circulent dans la ligne pilote chaque premier signal analogique afin de déduire de ce dernier la valeur maximale d'un courant que l'autre système est capable de lui fournir, et pour autoriser ou interdire cette fourniture de courant, au moins en fonction de cette valeur maximale déduite ;
   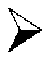 les moyens de gestion peuvent être agencés pour gérer la fourniture de puissance à une ou plusieurs batterie(s) électrique(s) rechargeable(s) faisant partie du véhicule ;
- il peut comprendre des moyens de traitement agencés pour fournir des signaux numériques locaux devant être transformés en seconds signaux analogiques à transmettre, et pour traiter des signaux numériques résultant de la conversion de seconds signaux analogiques extraits de la ligne pilote.

D'autres caractéristiques et avantages de l'invention apparaîtront à l'examen de la description détaillée ci-après, et des dessins annexés, sur lesquels :
- la figure 1 illustre schématiquement et fonctionnellement un premier système constituant une borne de recharge, équipé d'un exemple de réalisation d'un dispositif de communication selon l'invention et couplé, via un câble électrique, à un second système constituant un véhicule et équipé d'un même exemple de réalisation de dispositif de communication selon l'invention,
- la figure 2 illustre schématiquement et fonctionnellement un exemple de réalisation de moyens de génération de premier signal analogique du premier système de la figure 1,
- la figure 3 illustre schématiquement le résultat du traitement d'un signal rectangulaire par les moyens de génération de la figure 2,
- la figure 4 illustre schématiquement et fonctionnellement un exemple de réalisation du générateur de tension des premiers moyens de génération des dispositifs de communication de la figure 1,
- la figure 5 illustre schématiquement et fonctionnellement un exemple de réalisation du générateur de tension des seconds moyens de génération des dispositifs de communication de la figure 1, et
- la figure 6 illustre schématiquement et fonctionnellement un exemple de réalisation des moyens d'analyse du second système de la figure 1.

Les dessins annexés pourront non seulement servir à compléter l'invention, mais aussi contribuer à sa définition, le cas échéant.

L'invention a notamment pour but d'offrir un dispositif de communication Di (i = 1 ou 2) destiné à équiper un système Si devant être alimenté en tension par un autre système Si' (i' ≠ i) via un câble électrique (d'interconnexion) CE ou devant alimenter en tension un autre système Si' via un câble électrique (d'interconnexion) CE.

Dans ce qui suit, on considère, à titre d'exemple non limitatif, que le (premier) système S1 qui assure l'alimentation en tension est une borne de recharge (publique ou privée), et que le (second) système S2 qui doit être alimenté en tension est un véhicule automobile disposant d'une batterie électrique rechargeable (comme par exemple un véhicule hybride ou tout électrique). Mais l'invention n'est pas limitée à ces deux types de système. Elle concerne en effet tous les systèmes pouvant être interconnectés via un câble électrique ayant une ligne pilote en vue d'une alimentation en tension électrique nécessitant l'échange d'informations de types différents. Ainsi, l'invention concerne également les bâtiments, les installations industrielles et publiques, l'aéronautique, l'électronique grand public, le domaine ferroviaire et d'une façon générale tous les systèmes de fourniture d'énergie à ligne pilote.

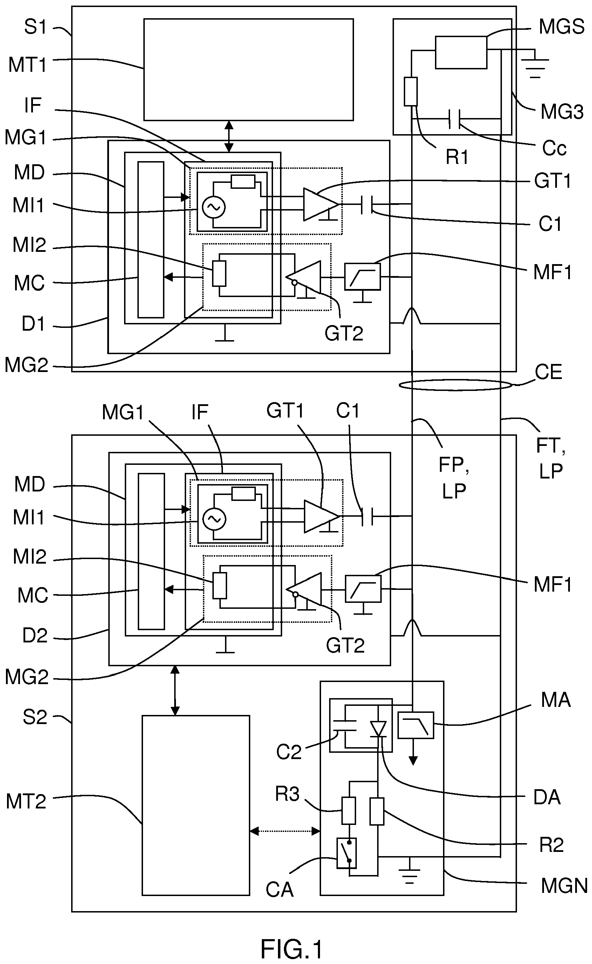

On a schématiquement représenté sur la figure 1 un premier système S1 (constituant ici une borne de recharge) et un second système (constituant ici un véhicule à batterie(s) rechargeable(s)), interconnectés l'un à l'autre par un câble électrique CE (ici dédié à l'alimentation en puissance).

Ce câble électrique CE comprend une ligne dite pilote LP, ayant un fil pilote FP et un fil de terre FT et présentant une première impédance, et des lignes de puissance (non représentées et chargées de fournir le courant au véhicule S2).

La borne de recharge S1 comprend au moins un module de génération MG3 et un dispositif de communication D1 selon l'invention, ainsi que de préférence des moyens de traitement MT1.

Les moyens de traitement MT1 (i = 1) peuvent être agencés sous la forme d'un calculateur (ou d'une unité de calcul électronique). Ils sont agencés, d'une part, pour fournir localement (c'est-à-dire à la borne de recharge S1 et en particulier à son dispositif de communication D1) des signaux numériques locaux qui devront être transformés en (seconds) signaux analogiques devant être transmis au véhicule S2, et, d'autre part, pour traiter des signaux numériques résultant de la conversion locale par le dispositif de communication D1 de (seconds) signaux analogiques extraits du câble électrique CE et issus du véhicule S2.

Le module de génération MG3 comprend notamment des moyens de génération MGS qui sont agencés pour générer un (premier) signal analogique dans une première bande de fréquences f1. Dans l'application considérée à titre d'exemple, la fréquence la plus basse de f1 peut être égale à 1 kHz (mais d'autres fréquences peuvent être utilisées (supérieures ou inférieures à 1 kHz)).

De préférence, les moyens de génération MGS sont agencés pour générer un premier signal analogique de type dit « à modulation de largeur d'impulsion » (ou PWM (« Pulse Width Modulation »)). Dans l'application considérée à titre d'exemple, la largeur d'impulsion du premier signal analogique est représentative de la valeur maximale du courant que la borne de recharge S1 est capable de fournir à l'instant considéré au véhicule S2.

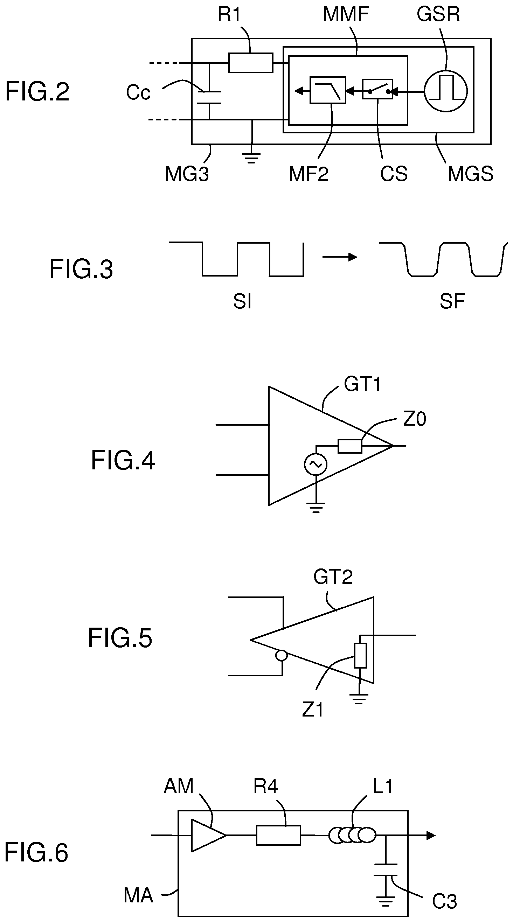

Encore plus préférentiellement, les moyens de génération MGS peuvent être agencés de manière à générer un premier signal analogique qui présente une forme générale rectangulaire à transitions arrondies, du type de celle illustrée schématiquement dans la partie droite SF de la figure 3.

Un tel signal rectangulaire à transitions arrondies SF peut être généré par des moyens de génération MGS qui sont par exemple du type de ceux illustrés sur la figure 2. Plus précisément, dans l'exemple non limitatif illustré sur la figure 2, les moyens de génération MGS comprennent un générateur GSR et des moyens de mise en forme MMF comprenant par exemple des moyens de commutation CS et des (seconds) moyens de filtrage MF2.

Le générateur GSR est agencé pour générer un signal initial SI de forme rectangulaire (comme illustré schématiquement dans la partie gauche de la figure 3) et ayant la fréquence la plus basse de la première bande de fréquences f1. Ce générateur GSR peut notamment comprendre un oscillateur.

Les moyens de commutation CS sont agencés pour modifier le passage du signal initial SI qui est généré par le générateur GSR pendant une petite partie choisie de chacune de ses transitions afin d'arrondir ces dernières. On entend ici par « transition » un brusque changement de tension, c'est-à-dire avec une pente forte. On comprendra que la commutation permet d'arrondir le début et la fin de chacune des transitions lorsque les temps d'ouverture et temps de fermeture sont suffisamment longs. Ces moyens de commutation CS peuvent par exemple comprendre un sous-système électronique à transistor(s) et/ou à amplificateur(s) opérationnel(s).

Les seconds moyens de filtrage MF2 sont agencés pour appliquer un filtrage de type passe-bas au signal à transitions arrondies qui est délivré par les moyens de commutation CS de manière à augmenter la durée de leurs transitions arrondies. Ils délivrent en sortie ce que l'on appelle ici le premier signal analogique SF. Ce filtrage peut par exemple être réalisé par un filtre de type RLC.

La mise en forme du signal initial PWM SI par les moyens de génération MGS, selon l'invention, permet de réduire son encombrement spectral au-delà de sa première fréquence fondamentale qui est dans ce cas aussi la fréquence la plus basse de la première bande de fréquences f1, et donc de réduire les interférences avec les seconds signaux analogiques SC qui sont ajoutés sur la ligne pilote LP par multiplexage fréquentiel, comme on le verra plus loin. Cela est vrai non seulement pendant les transitions, grâce à l'augmentation de leur durée, mais également pour tout intervalle de temps qui encadre le début ou la fin d'une transition, grâce à l'arrondi.

Les moyens de génération MGS comprennent une première borne qui est connectée à la liaison de la borne de recharge S1 qui correspond à la ligne pilote LP, via une première résistance R1, et une seconde borne qui est connectée à la terre et à la liaison de la borne de recharge S1 qui correspond à la ligne de terre LT. Par ailleurs, la borne de la première résistance R1, qui est opposée à celle connectée à l'une des bornes de sortie des moyens de génération MGS, est couplée à l'autre borne de sortie de ces moyens de génération MGS, et à la masse, via un composant capacitif Cc.

La première résistance R1 et le composant capacitif Cc font partie, avec les moyens de génération MGS, du module de génération MG3.

Le véhicule S2 comprend au moins des moyens de gestion MGN et un dispositif de communication D2 selon l'invention, ainsi que de préférence des moyens de traitement MT2.

Les moyens de traitement MT2 (i = 2) peuvent être agencés sous la forme d'un calculateur (ou d'une unité de calcul électronique). Ils sont agencés, d'une part, pour fournir localement (c'est-à-dire au véhicule S2 et en particulier à son dispositif de communication D2) des signaux numériques locaux qui devront être transformés en (seconds) signaux analogiques devant être transmis à la borne de recharge S1, et, d'autre part, pour traiter des signaux numériques résultant de la conversion locale par le dispositif de communication D2 de (seconds) signaux analogiques SC extraits de la ligne pilote LP et issus de la borne de recharge S1.

Les moyens de gestion MGN sont agencés pour extraire des (premiers SF et seconds SC) signaux analogiques qui circulent dans le câble électrique CE sur la ligne pilote LP les seuls premiers signaux analogiques SF afin de déduire de ces derniers la valeur maximale d'un courant que la borne de recharge S1 est capable de fournir au véhicule S2. Ils sont également agencés pour autoriser ou interdire cette fourniture de courant, au moins en fonction de la valeur maximale déduite d'un premier signal SF extrait.

Cette extraction peut se faire au moyen d'un module d'analyse MA assurant une fonction de filtrage sur laquelle on reviendra plus loin.

Ces moyens de gestion MGN sont également agencés pour gérer l'alimentation en tension du véhicule S2 et ici plus précisément de sa batterie électrique rechargeable (sous le contrôle d'un chargeur de batterie non représenté et dont ils font éventuellement partie). Pour ce faire, ils peuvent, comme illustré non limitativement, comprendre au moins une diode DA, couplée à la liaison du véhicule S2 qui est couplée à la ligne pilote LP, et une deuxième résistance R2 couplée à la diode DA et à la masse (qui est couplée à la ligne de terre LT).

La deuxième résistance R2 permet, lorsque l'interconnexion véhicule S2-borne de recharge S1 est conforme (en particulier en ce qui concerne la terre), de signaler cette conformité à la borne de recharge S1.

Comme illustré non limitativement sur la figure 1, les moyens de gestion MGN peuvent avantageusement comprendre également une troisième résistance R3 et un commutateur CA montés en parallèle de la deuxième résistance R2. Cette troisième résistance R3 et ce commutateur CA sont destinés à signaler à la borne de recharge S1 si elle est autorisée ou non à alimenter le véhicule en tension. On comprendra qu'une autorisation d'alimentation est donnée lorsque le commutateur CA est fermé, alors qu'une interdiction d'alimentation est donnée lorsque le commutateur CA est ouvert.

Par ailleurs, comme illustré non limitativement sur la figure 1, les moyens de gestion MGN peuvent avantageusement comprendre également un condensateur C2 monté en parallèle de la diode DA, de façon à rendre l'impédance de la ligne pilote LP (constituée des fil pilote FP et fil de terre FT) pendant les états hauts du premier signal analogique SF plus proche de celle qu'elle possède pendant les états bas dudit du premier signal analogique SF.

On notera que les moyens de traitement MT2 peuvent être éventuellement couplés aux moyens de gestion MGN, comme illustré non limitativement, afin de s'échanger des informations ou instructions.

On notera également qu'en raison des agencements décrits ci-avant de la borne de recharge S1 et du véhicule S2, le câble électrique CE voit au moins sur une première extrémité une deuxième impédance correspondant à celle de la première résistance R1, et sur une seconde extrémité (opposée à la première), quand la diode DA est passante, et dans une première approximation consistant à négliger les effets non linaires dus à cette diode DA, une troisième impédance correspondant à celle de la deuxième résistance R2, ainsi qu'éventuellement une cinquième impédance correspondant à celle de la troisième résistance R3.

Les dispositifs de communication Di (i = 1 ou 2), qui équipent respectivement la borne de recharge S1 et le véhicule S2, sont sensiblement identiques.

Selon l'invention, un dispositif de communication Di est agencé pour effectuer au moins trois fonctions.

Une première fonction consiste à générer à partir d'un signal numérique local (fourni par les éventuels moyens de traitement MTi associés) un second signal analogique de courants porteurs en ligne SC ayant des fréquences comprises dans une deuxième bande de fréquences qui recouvre le moins possible (et de préférence pas du tout ou de façon négligeable) la première bande de fréquences f1 (du premier signal analogique SF).

Par conséquent, le dispositif (de communication) Di est chargé de multiplexer en fréquence sur la ligne pilote LP les seconds signaux analogiques SC (qu'il génère) avec les premiers signaux analogiques SF (générés par la borne de recharge S1).

De préférence, la bande de fréquences des seconds signaux analogiques est située au-dessus de la première fréquence f1. Mais dans une variante de réalisation elle pourrait se situer en-dessous de la première bande de fréquences f1 selon un dispositif miroir.

A titre d'exemple non limitatif, la bande passante des seconds signaux analogiques peut être comprise entre environ 2 MHz et environ 30 MHz.

Une deuxième fonction consiste à alimenter la ligne pilote LP avec chaque second signal analogique généré SC via des moyens capacitifs C1 ayant une quatrième impédance, qui est de préférence strictement inférieure aux première, deuxième et troisième impédances (respectivement de la ligne pilote LP, de la première résistance R1, et de la deuxième résistance R2), ainsi qu'également à la cinquième impédance de l'éventuelle troisième résistance R3.

A titre d'exemple, la quatrième impédance (de sortie) du dispositif (de communication) Di peut être de dix fois à cent fois plus petite que celles des première, deuxième, troisième et éventuelle cinquième impédances.

Ceci est notamment justifié par le fait que la sortie des moyens capacitifs C1 est couplée à la liaison de la borne de recharge S1 ou du véhicule S2 qui correspond à la ligne pilote LP, et donc ces moyens capacitifs C1 définissent un pont diviseur avec les première R1, deuxième R2 et éventuelle troisième R3 résistances.

Une troisième fonction consiste à extraire des (premiers SF et seconds SC) signaux analogiques qui circulent dans la ligne pilote LP les seuls seconds signaux analogiques SC afin de les convertir en signaux numériques devant être traité par le système Si (par exemple par ses moyens de traitement MTi).

Afin de réaliser les première et troisième fonctions le dispositif Di peut, comme illustré non limitativement sur la figure 1, comprendre des moyens de conversion MC, des premiers moyens de génération MG1, des seconds moyens de génération MG2 et des premiers moyens de filtrage MF1.

Les moyens de conversion MC sont agencés pour convertir chaque signal analogique en un signal numérique à traiter localement (par exemple par les moyens de traitement MTi associés), et chaque signal numérique local (par exemple fourni par les moyens de traitement MTi associés) en un signal analogique. Il s'agit d'une fonction de type modem (modulation / démodulation).

Les premiers moyens de génération MG1 sont agencés pour générer chaque second signal analogique SC à partir d'un signal analogique local fourni par les moyens de conversion MC, et pour alimenter les moyens capacitifs C1 avec chaque second signal analogique SC généré afin qu'ils l'injectent dans la ligne pilote LP.

Pour ce faire, et comme illustré non limitativement sur la figure 1, les premiers moyens de génération MG1 peuvent comprendre des premiers moyens d'interface MI1 et un premier générateur de tension GT1 couplés entre eux.

Les premiers moyens d'interface MI1 sont agencés pour générer un premier signal analogique, et par exemple différentiel, de courants porteurs en ligne à partir d'un signal analogique fourni par les moyens de conversion MC.

Lorsque le premier signal est différentiel, l'une des deux sorties différentielles des premiers moyens d'interface MI1, par exemple celle du haut O+, délivre un signal analogique Vₒ₊ référencé par rapport à la masse, alors que l'autre sortie différentielle de ces premiers moyens d'interface MI1, par exemple celle du bas O-, délivre un signal analogique Vₒ₋ référencé par rapport à la masse.

De préférence, l'impédance de sortie Z0 des premiers moyens d'interface MI1 est inférieure ou égale à environ 10 Ω.

Le premier générateur de tension GT1 est agencé, d'une part, pour générer un second signal analogique de courants porteurs en ligne SC à partir d'un premier signal différentiel analogique généré par les premiers moyens d'interface MI1, et, d'autre part, pour alimenter les moyens capacitifs C1 avec le second signal analogique SC qu'il a généré. Un tel premier générateur de tension GT1 peut par exemple comporter un amplificateur opérationnel présentant un montage du type de celui illustré sur la figure 4 (c'est-à-dire avec une impédance de sortie Z0 et un générateur de tension montés en série entre sa borne de sortie et la masse, de sorte que sa sortie soit équivalente à une source de tension référencée par rapport à la masse et d'impédance interne Z0).

La sortie du premier générateur de tension GT1 délivre un second signal analogique SC qui est égal à la tension de O+ (Vₒ₊) moins la tension de O- (Vₒ₋) plus la masse (GND), soit SC - GND = Vₒ₊ - Vₒ₋. On notera que la ligne pilote LP est référencée par rapport au même potentiel que la masse GND des premiers moyens de génération MG1 (la terre est donc reliée à la masse par une impédance suffisamment faible). Le premier générateur de tension GT1 a préférablement une impédance de sortie Z0 faible, par exemple très petite par rapport à environ 100 Ω, notamment pour être faible devant les impédances des résistances R1, R2 et R3, et pour ne pas être grande devant la première impédance caractéristique de la ligne pilote LP aux fréquences des seconds signaux analogiques SC. Cela permet en effet de ne pas trop atténuer les seconds signaux analogiques SC qui sont injectés sur la ligne pilote LP.

Il est important de comprendre qu'un objectif du premier générateur de tension GT1 est de délivrer un second signal analogique SC qui n'est pas dégradé par la présence au niveau de sa sortie des impédances et des tensions propres à la ligne pilote LP, en particulier pendant les variations du premier signal analogique SF.

Les premiers moyens de filtrage MF1 sont agencés pour extraire chaque second signal analogique SC des signaux analogiques (SC + SF) qui circulent dans la ligne pilote LP.

Lorsque la bande de fréquences des seconds signaux analogiques SC est située au-dessus de la première bande de fréquences f1, les premiers moyens de filtrage MF1 sont agencés pour effectuer un filtrage de type passe-haut, et le module d'analyse MA des moyens de gestion MGN est agencé pour effectuer un filtrage de type passe-bas. On comprendra que si la bande de fréquences des seconds signaux analogiques SC était située en-dessous de la première fréquence f1, les premiers moyens de filtrage MF1 seraient agencés pour effectuer un filtrage de type passe-bas, et le module d'analyse MA des moyens de gestion MGN serait agencé pour effectuer un filtrage de type passe-haut.

L'impédance d'entrée ZI des premiers moyens de filtrage MF1 est préférablement élevée, par exemple supérieure à environ 100 kΩ, notamment de manière à être grande devant les impédances des résistances R1, R2 et R3 pour ne pas modifier l'action de ces dernières (R1 à R3). Dans le cas de seconds signaux analogiques SC dont la fréquence la plus basse est égale à environ 2 MHz, les premiers moyens de filtrage MF1 peuvent par exemple être d'ordre 2 (12 dB/octave) et avoir une fréquence de coupure d'environ 700 kHz.

On notera que le filtrage assuré par le module d'analyse MA peut par exemple être d'ordre 2 et avoir une fréquence de coupure d'environ 160 kHz. Un exemple de réalisation non limitatif du module d'analyse MA est illustré sur la figure 6. La référence AM désigne un amplificateur d'entrée. La référence R4 désigne une résistance montée en série avec l'amplificateur opérationnel AM. La référence L1 désigne une inductance montée en série avec l'amplificateur opérationnel AM et la résistance R4. La référence C3 désigne un élément capacitif monté en parallèle entre la sortie de l'inductance L1 et la masse de manière à former un circuit de type RLC.

Les filtrages d'ordre 2 ou 1 (6 dB/octave) permettent une implémentation à un coût réduit. De meilleures performances peuvent être obtenues avec des ordres (ou pentes) plus élevé(e)s, moyennant un coût pouvant être également plus élevé.

Les seconds moyens de génération MG2 sont agencés pour générer à partir de chaque second signal analogique extrait SC un signal analogique devant être converti en signal numérique par les moyens de conversion MC afin d'être traité par le système Si (par exemple par ses moyens de traitement MTi).

Pour ce faire, et comme illustré non limitativement sur la figure 1, les seconds moyens de génération MG2 peuvent comprendre un second générateur de tension GT2 et des seconds moyens d'interface MI2 couplés entre eux.

Le second générateur de tension GT2 est agencé pour générer un second signal analogique, et par exemple différentiel, de courants porteurs en ligne à partir d'un second signal analogique SC extrait par les premiers moyens de filtrage MF1 de la ligne pilote LP.

Un tel second générateur de tension GT2 peut par exemple comporter un amplificateur présentant un montage du type de celui illustré sur la figure 5 (c'est-à-dire avec une impédance d'entrée équivalente Z1 montée entre sa borne d'entrée et la masse).

L'une des deux sorties différentielles du second générateur de tension GT2, par exemple celle du haut I+, délivre un signal analogique V_{I+} référencé par rapport à la masse, alors que l'autre sortie différentielle de ce second générateur de tension GT2, par exemple celle du bas I- (ici inverseuse), délivre un signal analogique V_{I-} référencé par rapport à la masse.

Si la sortie des premiers moyens de filtrage MF1 délivre un second signal analogique SC', alors on a la relation SC' - GND = V_{I+} - V_{I-}.

Les seconds moyens d'interface MI2 sont agencés pour générer un signal analogique de courants porteurs en ligne, devant être converti en signal numérique par les moyens de conversion MC, à partir d'un second signal différentiel analogique fourni par le second générateur de tension GT2. Les seconds moyens d'interface MI2 peuvent comporter une entrée différentielle. Dans ce cas, il est préférable que la sortie du second générateur de tension GT2 soit aussi de type différentiel.

Par exemple, l'impédance d'entrée des seconds moyens d'interface MI2 peut être inférieure ou égale à environ 150 Ω, pour des raisons liées aux applications des composants considérés sur des lignes de puissance.

Les premiers MI1 et seconds MI2 moyens d'interface peuvent éventuellement constituer deux sous-parties d'un composant électronique IF appelé par l'homme de l'art « circuit analogique frontal » (ou en anglais AFE (pour « Analog Front End »)).

Par ailleurs, les moyens de conversion MC et le circuit analogique frontal IF peuvent éventuellement constituer deux sous-parties d'un modem pour courants porteurs en ligne MD (ou en anglais PLC chipset (pour « Power Line Communication chipset »)), bien connu de l'homme de l'art.

On notera que dans une variante de réalisation les premiers moyens de génération MG1 pourraient ne pas comprendre de premier générateur de tension GT1. Dans ce cas, l'une des deux sorties différentielles des premiers moyens d'interface MI1, par exemple O-, peut être reliée à la masse, de façon à délivrer directement le second signal analogique SC sur l'autre sortie différentielle des premiers moyens d'interface MI1, par exemple 0+.

On notera également que dans une variante de réalisation les seconds moyens de génération MG2 pourraient ne pas comprendre de second générateur de tension GT2. Dans ce cas, l'une des deux entrées différentielles des seconds moyens d'interface MI2 peut être reliée à la masse, de façon à recevoir le signal analogique SC' sur l'autre entrée différentielle des seconds moyens d'interface MI2. L'impédance de sortie des premiers moyens de filtrage MF1 doit alors tenir compte de l'impédance d'entrée RI des seconds moyens d'interface MI2, qui, dans le cas d'une appartenance à un AFE IF, est en général inférieure à 150 Ω.

L'invention permet avantageusement de diminuer, voire quasiment supprimer, la diaphonie, notamment du fait que les communications peuvent être désormais considérées comme de type « point à point ». Cela résulte du fait que les premiers et seconds signaux sont filtrés à la plupart des interfaces que chaque système Si a avec l'extérieur, contrairement aux technologies de l'art antérieur dans lesquelles les courants porteurs en ligne sont appliqués aux lignes de puissance qui sont en général électriquement interconnectées.

Par ailleurs, l'invention est applicable à de nombreux types de technologie à courants porteurs en ligne, dans de nombreuses bandes de fréquences, notamment situées entre 80 kHz et 30 MHz.

L'invention ne se limite pas aux modes de réalisation de dispositif de communication et de systèmes décrits ci-avant, seulement à titre d'exemple, mais elle englobe toutes les variantes que pourra envisager l'homme de l'art dans le cadre des revendications ci-après.

## Revendications

1. Dispositif de communication par courants porteurs en ligne (D1, D2) pour un système (S1, S2) propre à être couplé à un autre système (S2, S1) via un câble électrique (CE) comportant une ligne pilote (LP) ayant une première impédance, voyant au moins des deuxième et troisième impédances et dans laquelle circule un premier signal analogique dans une première bande de fréquences, **caractérisé en ce qu'**il est agencé i) pour générer à partir d'un signal numérique local un second signal analogique de courants porteurs en ligne ayant des fréquences comprises dans une deuxième bande de fréquences recouvrant le moins possible ladite première bande de fréquences, ii) pour alimenter ladite ligne pilote (LP) avec ledit second signal analogique via des moyens capacitifs (C1), et iii) pour extraire des signaux analogiques circulant dans ladite ligne pilote (LP) chaque second signal analogique afin de le convertir en signal numérique devant être traité par ledit système (Si).

2. Dispositif selon la revendication 1, **caractérisé en ce que** lesdits moyens capacitifs (C1) présentent une quatrième impédance qui est strictement inférieure auxdites première, deuxième et troisième impédances.

3. Dispositif selon l'une des revendications 1 et 2, **caractérisé en ce qu'**il comprend i) des moyens de conversion (MC) propres à convertir un signal analogique en un signal numérique et réciproquement, ii) des premiers moyens de génération (MG1) propres à générer chaque second signal analogique à partir d'un signal analogique local fourni par lesdits moyens de conversion (MC), et à alimenter lesdits moyens capacitifs (C1) avec chaque second signal analogique généré, iii) des premiers moyens de filtrage (MF1) propres à extraire chaque second signal analogique des signaux analogiques circulant dans ladite ligne pilote (LP), et iv) des seconds moyens de génération (MG2) propres à générer à partir de chaque second signal analogique extrait un signal analogique devant être converti en signal numérique par lesdits moyens de conversion (MC), en vue de son traitement par ledit système (Si).

4. Dispositif selon la revendication 3, **caractérisé en ce que** lesdits premiers moyens de génération (MG1) comprennent i) des premiers moyens d'interface (MI1) agencés pour générer un premier signal différentiel analogique de courants porteurs en ligne à partir d'un signal analogique fourni par lesdits moyens de conversion (MC), et ii) un premier générateur de tension (GT1) agencé pour générer un second signal analogique de courants porteurs en ligne à partir d'un premier signal différentiel analogique généré par lesdits premiers moyens d'interface (MI1), et pour alimenter lesdits moyens capacitifs (C1) avec ledit second signal analogique généré.

5. Dispositif selon l'une des revendications 3 et 4, **caractérisé en ce que** lesdits seconds moyens de génération (MG2) comprennent i) un second générateur de tension (GT2) agencé pour générer un second signal différentiel analogique de courants porteurs en ligne à partir d'un second signal analogique extrait par lesdits premiers moyens de filtrage (MF1), et ii) des seconds moyens d'interface (MI2) agencés pour générer un signal analogique de courants porteurs en ligne devant être converti en signal numérique par lesdits moyens de conversion (MC), à partir d'un second signal différentiel analogique fourni par ledit second générateur de tension (GT2).

6. Dispositif selon l'une des revendications 3 à 5, **caractérisé en ce que** lesdits premiers moyens de filtrage (MF1) sont agencés pour extraire des signaux analogiques circulant dans ladite ligne pilote (LP) des seconds signaux analogiques appartenant à une deuxième bande de fréquences supérieure à ladite première bande de fréquences.

7. Système (S1, S2) propre à être couplé à un autre système (S2, S1) via un câble électrique (CE) comportant une ligne pilote (LP) ayant une première impédance, voyant au moins des deuxième et troisième impédances et dans laquelle circule un premier signal analogique dans une première bande de fréquences, **caractérisé en ce qu'**il comprend un dispositif de communication par courants porteurs en ligne (D1, D2) selon l'une des revendications précédentes, destiné à être couplé à ladite ligne pilote (LP).

8. Système selon la revendication 7, **caractérisé en ce qu'**il constitue une partie au moins d'une borne de recharge, et **en ce qu'**il comprend des moyens de génération (MGS) agencés pour générer ledit premier signal analogique.

9. Système selon la revendication 8, **caractérisé en ce que** lesdits moyens de génération (MGS) sont agencés pour générer un premier signal analogique de type dit « à modulation de largeur d'impulsion », et dans lequel ladite largeur d'impulsion est représentative de la valeur maximale d'un courant que ladite borne de recharge est capable de fournir.

10. Système selon la revendication 9, **caractérisé en ce que** lesdits moyens de génération (MGS) sont agencés pour générer un premier signal analogique présentant une forme générale rectangulaire à transitions arrondies.

11. Système selon la revendication 10, **caractérisé en ce que** lesdits moyens de génération (MGS) comprennent i) un générateur (GSR) agencé pour générer un signal de forme rectangulaire ayant la fréquence la plus basse de ladite première bande de fréquences, ii) des moyens de commutation (CS) agencés pour modifier le passage du signal généré par ledit générateur (GSR) pendant une petite partie choisie de chacune de ses transitions de manière à arrondir ces dernières, et iii) des seconds moyens de filtrage (MF2) agencés pour appliquer un filtrage de type passe-bas au signal délivré par lesdits moyens de commutation (CS) de manière à augmenter la durée de leurs transitions arrondies.

12. Système selon la revendication 7, **caractérisé en ce qu'**il constitue une partie au moins d'un véhicule, et **en ce qu'**il comprend des moyens de gestion (MGN) agencés pour extraire des signaux analogiques circulant dans ladite ligne pilote (LP) chaque premier signal analogique afin de déduire de ce dernier la valeur maximale d'un courant que ledit autre système (S2, S1) est capable de fournir audit système (S1, S2) et pour autoriser ou interdire cette fourniture de courant au moins en fonction de cette valeur maximale déduite.

13. Système selon la revendication 12, **caractérisé en ce que** lesdits moyens de gestion (MGN) sont agencés pour gérer la fourniture de puissance à au moins une batterie électrique rechargeable faisant partie dudit véhicule.

14. Système selon l'une des revendications 7 à 13, **caractérisé en ce qu'**il comprend des moyens de traitement (MTi) agencés pour fournir des signaux numériques locaux devant être transformés en seconds signaux analogiques à transmettre, et pour traiter des signaux numériques résultant de la conversion de seconds signaux analogiques extraits de ladite ligne pilote (LP).

## Patentansprüche

1. Kommunikationsvorrichtung unter Verwendung von Stromleitungskommunikation (D1, D2) für ein System (S1, S2), das zur Kopplung an ein anderes System (S2, S1) über ein elektrisches Kabel (CE) geeignet ist, das eine Steuerleitung (LP) mit einer ersten Impedanz umfasst, die mindestens eine zweite und eine dritte Impedanz aufweist und in der ein erstes analoges Signal in einem ersten Frequenzband zirkuliert, **dadurch gekennzeichnet, dass** sie ausgebildet ist i) zum Generieren aus einem lokalen digitalen Signal eines zweiten analogen Signals der Stromleitungskommunikation mit Frequenzen, die in einem zweiten Frequenzband vorliegen, das so wenig wie möglich das erste Frequenzband abdeckt, ii) zum Versorgen der Steuerleitung (LP) mit dem zweiten analogen Signal über kapazitive Mittel (C1), und iii) zum Extrahieren analoger Signale, die in der Steuerleitung (LP) jedes zweiten analogen Signals zirkulieren, um es in ein von dem System (Si) zu verarbeitendes digitales Signal umzuwandeln.

2. Vorrichtung nach Anspruch 1, **dadurch gekennzeichnet, dass** die kapazitiven Mittel (C1) eine vierte Impedanz aufweisen, die strikt kleiner ist als die erste, zweite und dritte Impedanz.

3. Vorrichtung nach einem der Ansprüche 1 und 2, **dadurch gekennzeichnet, dass** sie i) Umwandlungsmittel (MC), die geeignet sind zum Umwandeln eines analogen Signals in ein digitales Signal und umgekehrt, ii) erste Generierungsmittel (MG1), die geeignet sind zum Generieren jedes zweiten analogen Signals aus einem von den Umwandlungsmitteln (MC) gelieferten lokalen analogen Signal und zum Versorgen der kapazitiven Mittel (C1) mit jedem generierten zweiten analogen Signal, iii) erste Filtermittel (MF1) zum Extrahieren jedes zweiten analogen Signals aus analogen Signalen, die in der Steuerleitung (LP) zirkulieren, und iv) zweite Generierungsmittel (MG2) zum Generieren eines analogen Signals aus jedem zweiten analogen Signal, das durch die Umwandlungsmittel (MC) in ein digitales Signal umgewandelt werden soll, zu deren Verarbeitung durch das System (Si), umfasst.

4. Vorrichtung nach Anspruch 3, **dadurch gekennzeichnet, dass** die ersten Generierungsmittel (MG1) i) erste Schnittstellenmittel (MI1), die ausgebildet sind zum Generieren eines ersten analogen Differenzsignals der Stromleitungskommunikation aus einem von den Umwandlungsmitteln (MC) gelieferten analogen Signal und ii) einen ersten Spannungsgenerator (GT1), der ausgebildet ist zum Generieren eines zweiten analogen Signals der Stromleitungskommunikation aus einem von den ersten Schnittstellenmitteln (MI1) generierten ersten analogen Differenzsignal und zum Versorgen der kapazitiven Mittel (C1) mit dem generierten zweiten analogen Signal, umfassen.

5. Vorrichtung nach einem der Ansprüche 3 und 4, **dadurch gekennzeichnet, dass** die zweiten Generierungsmittel (MG2) i) einen zweiten Spannungsgenerator (GT2), der ausgebildet ist zum Generieren eines zweiten analogen Differenzsignals der Stromleitungskommunikation aus einem durch die ersten Filtermittel (MF1) extrahierten zweiten analogen Signal, und ii) zweite Schnittstellenmittel (MI2), die ausgebildet sind zum Generieren eines analogen Signals der Stromleitungskommunikation, das durch die Umwandlungsmittel (MC) in ein digitales Signal umgewandelt werden soll, aus einem zweiten analogen Differenzsignal, das durch den zweiten Spannungsgenerator (GT2) geliefert wird, umfassen.

6. Vorrichtung nach einem der Ansprüche 3 bis 5, **dadurch gekennzeichnet, dass** die ersten Filtermittel (MF1) zum Extrahieren analoger Signale, die in der Steuerleitung (LP) zirkulieren, aus zweiten analogen Signalen, die zu einem zweiten Frequenzband gehören, das höher als das erste Frequenzband ist, ausgebildet sind.

7. System (S1, S2), das zur Kopplung an ein anderes System (S2, S1) über ein elektrisches Kabel (CE) geeignet ist, das eine Steuerleitung (LP) mit einer ersten Impedanz umfasst, die mindestens eine zweite und eine dritte Impedanz aufweist und in der ein erstes analoges Signal in einem ersten Frequenzband zirkuliert, **dadurch gekennzeichnet, dass** es eine Kommunikationsvorrichtung unter Verwendung von Stromleitungskommunikation (D1, D2) nach einem der vorstehenden Ansprüche umfasst, die zur Kopplung an die Steuerleitung (LP) bestimmt sind.

8. System nach Anspruch 7, **dadurch gekennzeichnet, dass** es mindestens einen Teil einer Ladestation bildet, und dass es Generierungsmittel (MGS) umfasst, die zum Generieren des ersten analogen Signals ausgebildet sind.

9. System nach Anspruch 8, **dadurch gekennzeichnet, dass** die Generierungsmittel (MGS) zum Generieren eines ersten analogen sogenannten "impulsbreitenmodulierten" Signals ausgebildet sind, und wobei die Impulsbreite für den Maximalwert eines Stroms repräsentativ ist, den die Ladestation liefern kann.

10. System nach Anspruch 9, **dadurch gekennzeichnet, dass** die Generierungsmittel (MGS) zum Generieren eines ersten analogen Signals mit einer allgemein rechteckigen Form mit abgerundeten Übergängen ausgebildet sind.

11. System nach Anspruch 10, **dadurch gekennzeichnet, dass** die Generierungsmittel (MGS) i) einen Generator (GSR), der ausgebildet ist zum Generieren eines rechteckigen Signals mit der niedrigsten Frequenz des ersten Frequenzbandes, ii) Schaltmittel (CS), die ausgebildet sind zur Modifikation des Durchgangs des von dem Generator (GSR) generierten Signals während eines kleinen aus jedem seiner Übergänge ausgewählten Teils, so dass letztere abgerundet werden, und iii) zweite Filtermittel (MF2), die ausgebildet sind zur Anwendung einer Tiefpassfilterung auf das von den Schaltmitteln (CS) gelieferte Signal, so dass die Dauer ihrer abgerundeten Übergänge erhöht wird, umfassen.

12. System nach Anspruch 7, **dadurch gekennzeichnet, dass** es mindestens einen Teil eines Fahrzeugs bildet, und dass es Verwaltungsmittel (MGN) umfasst, die zum Extrahieren analoger Signale ausgebildet sind, die in der Steuerleitung (LP) jedes ersten analogen Signals zirkulieren, um aus dem letzteren den Maximalwert eines Stroms abzuleiten, den das andere System (S2, S1) an das System (S1, S2) liefern kann, und um diese Stromversorgung zumindest in Abhängigkeit von diesem abgeleiteten Maximalwert zu erlauben oder zu verbieten.

13. System nach Anspruch 12, **dadurch gekennzeichnet, dass** die Verwaltungsmittel (MGN) zum Verwalten der Stromversorgung von mindestens einer wiederaufladbaren elektrischen Batterie, die Teil des Fahrzeugs ist, ausgebildet sind.

14. System nach einem der Ansprüche 7 bis 13, **dadurch gekennzeichnet, dass** es Verarbeitungsmittel (MTi) umfasst, die zum Liefern von lokalen digitalen Signalen, die in zweite zu übertragende analoge Signale umgewandelt werden sollen, und zum Verarbeiten von digitalen Signalen, die aus der Umwandlung von zweiten analogen Signalen, die aus der Steuerleitung (LP) extrahiert werden, resultieren, ausgebildet sind.

## Claims

1. Power line communication device (D1, D2) for a system (S1, S2) designed to be combined with another system (S2, S1) through an electric cable (CE) comprising a pilot line (LP) that has a first impedance, provided with at least a second and third impedance and carries a first analogue signal in a first frequency band, **characterised in that** it is arranged i) to use a local digital signal to generate a second analogue signal of in-line carrier currents with frequencies ranging within a second frequency band that covers said first frequency band as little as possible; ii) to supply said pilot line (LP) with said second analogue signal through capacitive means (C1); and iii) to extract from the analogue signals flowing through said pilot line (LP), each second analogue signal in order to convert it into digital signals that can be processed by said system (Si).

2. Device according to claim 1 **characterised in that** said capacitive means (C1) has a fourth impedance that is absolutely lower than said first, second and third impedances.

3. Device according to any of claims 1 and 2 **characterised in that** it comprises i) conversion means (MC) designed to convert an analogue signal into a digital signal and vice versa; ii) first generation means (MG1) designed to generate each second analogue signal from a local analogue signal delivered by said conversion means (MC) and to supply said capacitive means (C1) with each second signal generated; iii) first filtering means (MF1) designed to extract each second analogue signal from the analogue signals flowing in said pilot line (LP); and iv) second generation means (MG2) designed to use each second analogue signal extracted to generate an analogue signal that will be converted into a digital signal by said conversion means (MC) for it to be processed by said system (Si).

4. Device according to claim 3 **characterised in that** said first generation means (MG1) comprise i) first interface means (MI1) arranged to generate a first analogue differential signal of in-line carrier currents using an analogue signal delivered by said conversion means (MC); and ii) a first voltage generator (GT1) arranged to generate a second analogue signal of in-line carrier currents using a first analogue differential signal generated by said first interface means (MI1), and to supply said capacitive means (C1) with said second analogue signal generated.

5. Device according to any of claims 3 and 4 **characterised in that** said second generation means (MG2) comprise i) a second voltage generator (GT2) arranged to generate a second analogue differential signal of in-line carrier currents using a second analogue signal extracted by said first filtering means (MF1); and ii) second interface means (MI2) arranged to generate an analogue signal of in-line carrier currents that will be converted into a digital signal by said conversion means (MC) using a second analogue differential signal delivered by said voltage generator (GT2).

6. Device according to any of claims 3 to 5 **characterised in that** said first filtering means (MF1) are arranged to extract from the analogue signals flowing through said pilot line (LP), second analogue signals belonging to a second frequency band that is higher than said first frequency band.

7. System (S1, S2) designed to be combined with another system (S2, S1) through an electric cable (CE) comprising a pilot line (LP) that has a first impedance, provided with at least a second and third impedances and carries a first analogue signal in a first frequency band, **characterised in that** it comprises a power line communication device (D1, D2), according to any of the previous claims, designed to be combined with said pilot line (LP).

8. System according to claim 7 **characterised in that** it forms at least part of a charging station, and **in that** it comprises generation means (MGS) arranged to generate said first analogue signal.

9. System according to claim 8 **characterised in that** said generation means (MGS) are arranged to generate a first analogue signal of the type known as "pulse width modulation", wherein said pulse width represents the maximum value of a current that said charging station can deliver.

10. System according to claim 9 **characterised in that** said generation means (MGS) are arranged to generate a first analogue signal that has a generally rectangular shape with rounded-off transitions.

11. System according to claim 10 **characterised in that** said generation means (MGS) comprise i) a generator (GSR) arranged to generate a rectangular-shaped signal that has the lowest frequency in said first frequency band; ii) switching means (CS) arranged to change the flow of the signal generated by said generator (GSR) during a small chosen part of each of its transitions, so that the latter are rounded off; and iii) second filtering means (MF2) arranged to carry out a low-pass filtering of the signal delivered by said switching means (CS), so that the duration of their rounded-off transitions is increased.

12. System according to claim 7 **characterised in that** it is at least part of a vehicle, and **in that** it comprises management means (MGN) arranged to extract from the analogue signals flowing through said pilot line (LP) each first analogue signal in order to deduct from the latter the maximum value of a current that said other system (S2, S1) can supply to said system (S1, S2), and to either authorise or prohibit the delivery of current at least according to the maximum value deducted.

13. System according to claim 12 **characterised in that** said management means (MGN) are arranged to manage the power supply to at least a rechargeable electric battery being part of said vehicle.

14. System according to any of claims 7 to 13 **characterised in that** it comprises processing means (MTi) arranged to deliver local digital signals that are to be transformed into second analogue signals to be transmitted, and to process digital signals obtained by converting the second analogue signals extracted from said pilot line (LP).
